# EUROPEAN PATENT SPECIFICATION

(11) **EP 3 037 870 B1**
(45) Date of publication and mention of the grant of the patent: **31.07.2019**
(21) Application number: 15164946.4
(22) Date of filing: 24.04.2015
(51) Int. Cl.: C08K 5/00, B29D 11/00, B32B 7/06, B32B 27/08, B32B 37/26, C09J 7/29, G02F 1/1333, G02F 1/13, B32B 7/12, B32B 27/36, B32B 27/30, B32B 37/12, H05K 5/03, H05K 5/00

(54) **PROTECTING FILM AND DISPLAY MODULE INCLUDING THE SAME**
SCHUTZFILM UND ANZEIGEMODUL DAMIT
FILM DE PROTECTION ET MODULE D'AFFICHAGE COMPRENANT CELUI-CI

(30) Priority: 03.12.2014 KR 20140172568; 19.03.2015 KR 20150038028
(43) Date of publication of application: 29.06.2016
(73) Proprietor: LG Display Co., Ltd., SEOUL, 07336 (KR)
(72) Inventor: Kim, TaeHa, 153-014 Seoul (KR); Lee, HyungSuk, 413-200 Paju-si, Gyeonggi-do (KR); Lee, HyeJung, 413-200 Paju-si, Gyeonggi-do (KR); Kim, SeungGi, 431-747 Anyang-si, Gyeonggi-do (KR); Cho, Seunghyun, 706-814 Daegu (KR)
(74) Representative: Ter Meer Steinmeister & Partner

(56) References cited:
- US-A1- 2012 202 055

## Description

### BACKGROUND

### Field of the Disclosure

Embodiments of the present invention relate to a protecting film, and more particularly, to a protecting film capable of being attached to a cover plate, and a display module including the cover plate with the protecting film attached thereto.

### Discussion of the Related Art

A cover plate is prepared to a front surface of a display module such as a liquid crystal display device or an organic light emitting display device. The display module may include a display panel for displaying an image, and the cover plate attached to a front surface of the display panel. In order to protect a surface of the cover plate for a manufacturing process, a protecting film is attached to the surface of the cover plate.

The protecting film enables to prevent the surface of the cover plate from being contaminated by foreign matters, spots or scratches. Under the condition that the protecting film is attached to the surface of the cover plate, various manufacturing processes are carried out.

US 2012 202055 A1 relates to a pressure-sensitive adhesive sheet provided with a substrate film comprising a transparent resin material, an antistatic layer provided on a first side thereof, and a pressure-sensitive adhesive layer provided on a second side thereof, wherein the antistatic layer contains an antistatic component and a binder resin, and has an average thickness of 1 nm to less than 100 nm.

### SUMMARY

For an entire manufacturing process of the display module, the protecting film is continuously attached to the surface of the cover plate. Due to the protecting film attached to the surface of the cover plate, it may be difficult to smoothly carry out the manufacturing process. For example, in the case that the protecting film is wrinkled or folded, it is difficult to obtain an accurate image when carrying out an image inspection process, which might cause a problem in sorting of defective one. Even though the protecting film is not wrinkled or folded, an accuracy of the image inspection process may be lowered in the case that the protecting film has a low light transmittance. For these reasons, in case of the related art, the protecting film is replaced in accordance with the properties required for each manufacturing process. However, if replacing the protecting film by each manufacturing process, a manufacturing time and cost are increased due to removing, cleaning and re-attaching steps of the protecting film. In addition, the surface of the cover plate may be damaged due to the repetitive replacement of the protecting film.

Research and development has been done by the inventors to reduce a burden for the replacement of protecting film by each manufacturing process. As a result, a structure of the protecting film fulfilling the various properties required for the respective manufacturing processes has been completed by the inventors.

Accordingly, embodiments of the present invention are directed to a protecting film that substantially obviates one or more problems due to limitations and disadvantages of the related art.

An aspect of embodiments of the present invention is directed to provide a protecting film capable of being attached to a cover plate, and a display module including the cover plate with the protecting film attached thereto.

Additional advantages and features of embodiments of the invention will be set forth in part in the description which follows and in part will become apparent to those having ordinary skill in the art upon examination of the following or may be learned from practice of embodiments of the invention. The objectives and other advantages of embodiments of the invention may be realized and attained by the structure particularly pointed out in the written description and claims hereof as well as the appended drawings.

To achieve these and other advantages and in accordance with the purpose of embodiments of the invention, as embodied and broadly described herein, there is provided a display module according to claim 5 comprising a display panel and a cover plate with a protecting film according to claims 1 to 4, wherein the protecting film, which comprises an anti-static layer, a base layer and an adhesive layer containing an anti-static agent, is configured to satisfy at least one among a plurality of properties comprising peel-off static, hardness, reflectance and surface roughness, that are required in a process of attaching the protecting film to the cover plate and in a process of attaching the cover plate with the protecting film attached thereto to the display panel, in order to preclude the need for replacement during the process of attaching the protecting film to the cover plate and the process of attaching the cover plate with the protecting film attached thereto to the display panel.

At this time, the anti-static agent has a coordinate covalent bonding of polyelectrolyte and fluorine-based conductive functional group so as to obtain the peel-off static property required in the process of attaching the protecting film to the cover plate.

Also, the hardness of the adhesive layer is a pencil hardness of 4B or greater so as to minimize a deformation of the adhesive layer due to external pressure applied in the process of attaching the protecting film to the cover plate.

In addition, the reflectance of the protecting film is 11% or less and a reflectance deviation is 3% or less so as to facilitate alignment control between the cover plate and the display panel in the process of attaching the cover plate with the protecting film attached thereto to the display panel.

In addition, the surface roughness of the anti-static layer is within a range so as to carry out a process of fixing or transferring the protecting film using a vacuum suction method.

In a reference aspect, there is provided a method of manufacturing a display module that may comprise removing a release layer from a protecting film, which initially comprises the release layer, an adhesive layer, a base layer and an anti-static layer; attaching the protecting film which the release layer is removed therefrom to at least one surface of a cover plate; in case the protecting film is attached to only a first surface of the cover plate, then placing an opposing second surface of the cover plate in contact with a bonding layer on one surface of a display panel for attachment thereto; in case the protecting film is attached to both the first surface and the opposing second surface of the cover plate, then removing the protecting film from the opposing second surface of the cover plate, and placing the opposing second surface of the cover plate in contact with a bonding layer on one surface of the display panel for attachment thereto; curing the bonding layer; carrying out an image inspection for the display panel; and removing the protecting film from the first surface of the cover plate.

At this time, the process of removing the release layer from the protecting film includes fixing the protecting film in a vacuum suction method, wherein a surface roughness of the anti-static layer is within a range so as to perform vacuum suction.

Also, a surface resistance of the adhesive layer is 10¹¹ Ω/□(ohms per square) or less and a peel-off static of the adhesive layer is 1kv or less, so as to minimize static electricity caused by a frictional force occurring during the process of removing the release layer from the protecting film. The anti-static agent included in the adhesive layer comprises a polyelectrolyte and an ion-type conductive functional group chemically bonded to the polyelectrolyte.

In addition, the process of attaching the protecting film to the at least one surface of the cover plate includes attaching the adhesive layer to the at least one surface of the cover plate, and the process of removing the protecting film from the opposing second surface of the cover plate includes removing the adhesive layer from one surface of the cover plate, wherein the adhesive layer has an adhesiveness from 29.4 mN/25mm to 88.2 mN/25mm (= 3 gf/25mm to 9 gf/25 mm), a hardness of a pencil hardness of 4B or greater and a tackiness from 33.32mN to 46.06mN (= 34gf to 47gf) to facilitate attachment and detachment of the adhesive layer.

In addition, the process of attaching the opposing second surface of the cover plate to the bonding layer on one surface of the display panel includes aligning a position of the cover plate through the use of a video camera, wherein a reflectance of the protecting film is 11% or less and a reflectance deviation of the protecting film is 3% or less so as to facilitate the process of aligning the position of the cover plate.

In addition, the process of curing the bonding layer includes irradiating light through the protecting film attached to one surface of the cover plate, and the process of inspecting an image for the display panel is carried out by positioning an image inspection device above the protecting film, wherein a light transmittance of the protecting film is 88.5% or more, a light transmittance deviation of the protecting film is 3% or less, a haze of the protecting film is 5.5% or less, and a haze deviation of the protecting film is 2% or less so as to facilitate the process of curing the bonding layer and inspecting the image.

In addition, the process of curing the bonding layer includes pre-curing the bonding layer after attaching the opposing second surface of the cover plate to the bonding layer; performing defect inspection for the cover plate; and carrying out a main curing process of the bonding layer when it is determined that there is no defect in the cover plate based on a result of the defect inspection.

In another reference aspect, there is provided a protecting film that may comprise an anti-static layer on one surface of a base layer; and an adhesive layer on the other surface of the base layer, wherein the adhesive layer comprises an anti-static agent in which a polyelectrolyte and an ion-type conductive functional group are chemically bonded.

At this time, the ion-type conductive functional group comprises a fluorine-based conductive functional group coordinate covalent bonded to the polyelectrolyte.

Also, a hardness of the adhesive layer is a pencil hardness of 4B or greater.

In addition, the adhesive layer comprises acryl-based polymer including a hard type non-functional monomer and a functional monomer containing a hydroxyl group.

In addition, the adhesive layer has a surface resistance of 10¹¹ Ω/□(οhms per square) or less, a peel-off static of 1kv or less, an adhesiveness from 29.4 mN/25mm to 88.2 mN/25mm (= 3 gf/25mm to 9 gf/25 mm), and a tackiness from 33.32mN to 46.06mN (= 34gf to 47gf).

In addition, a reflectance of the protecting film is 11% or less, a reflectance deviation of the protecting film is 3% or less, a light transmittance of the protecting film is 88.5% or more, a light transmittance deviation of the protecting film is 3% or less, a haze of the protecting film is 5.5% or less, and a haze deviation of the protecting film is 2% or less.

It is to be understood that both the foregoing general description and the following detailed description of embodiments of the present invention are exemplary and explanatory and are intended to provide further explanation of the invention as claimed.

### BRIEF DESCRIPTION OF THE DRAWINGS

The accompanying drawings, which are included to provide a further understanding of embodiments of the invention and are incorporated in and constitute a part of this application, illustrate embodiment(s) of the invention and together with the description serve to explain the principle of embodiments of the invention. In the drawings:
FIG. 1 is a cross sectional view illustrating a protecting film according to one embodiment of the present invention;
FIG. 2 is a cross sectional view illustrating a display module according to one embodiment of the present invention;
FIGs. 3A to 3E are cross sectional views illustrating a method for manufacturing the display module according to a reference aspect; and
FIG. 4 is a flow chart showing a process for attaching a cover plate to a display panel according to another reference aspect.

### DETAILED DESCRIPTION OF THE INVENTION

Reference will now be made in detail to the exemplary embodiments of the present invention, examples of which are illustrated in the accompanying drawings. Wherever possible, the same reference numbers will be used throughout the drawings to refer to the same or like parts.

Advantages and features of the present invention, and implementation methods thereof will be clarified through following embodiments described with reference to the accompanying drawings. The present invention may, however, be embodied in different forms and should not be construed as limited to the embodiments set forth herein. Rather, these embodiments are provided so that this disclosure will be thorough and complete, and will fully convey the scope of the present invention, which is defined in the appended claims, to those skilled in the art. Further, the present invention is only defined by scopes of claims.

A shape, a size, a ratio, an angle, and a number disclosed in the drawings for describing embodiments of the present invention are merely an example, and thus, the present invention is not limited to the illustrated details. Like reference numerals refer to like elements throughout. In the following description, when the detailed description of the relevant known function or configuration is determined to unnecessarily obscure the important point of the present invention, the detailed description will be omitted. In a case where 'comprise', 'have', and 'include' described in the present specification are used, another part may be added unless 'only∼' is used. The terms of a singular form may include plural forms unless referred to the contrary. In construing an element, the element is construed as including an error region although there is no explicit description.

In description of embodiments of the present invention, when a structure (for example, an electrode, a line, a wiring, a layer, or a contact) is described as being formed at an upper portion/lower portion of another structure or on/under the other structure, this description should be construed as including a case where the structures contact each other and moreover, a case where a third structure is disposed therebetween.

In describing a time relationship, for example, when the temporal order is described as 'after∼', 'subsequent∼', 'next∼', and 'before∼', a case which is not continuous may be included unless 'just' or 'direct' is used.

It will be understood that, although the terms "first", "second", etc. may be used herein to describe various elements, these elements should not be limited by these terms. These terms are only used to distinguish one element from another. For example, a first element could be termed a second element, and, similarly, a second element could be termed a first element, without departing from the scope of the present invention as defined in the appended claims.

Features of various embodiments of the present invention may be partially or overall coupled to or combined with each other, and may be variously inter-operated with each other and driven technically as those skilled in the art can sufficiently understand. The embodiments of the present invention may be carried out independently from each other, or may be carried out together in co-dependent relationship.

Hereinafter, a protecting film according to the embodiment of the present invention and a display module including the same will be described with reference to the accompanying drawings.

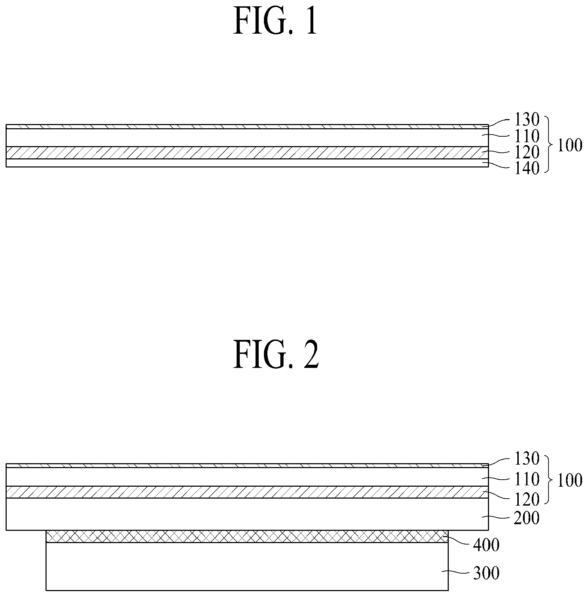

FIG. 1 is a cross sectional view illustrating a protecting film according to one embodiment of the present invention.

As shown in FIG. 1, the protecting film 100 according to one embodiment of the present invention may include a base layer 110, an adhesive layer 120, an anti-static layer 130, and a release layer 140.

The base layer 110 is disposed between the adhesive layer 120 and the anti-static layer 130. If the base layer 110 is deformed due to high temperature or humidity, the protecting film 100 is wrinkled or folded. Preferably, the base layer 110 has heat-resisting and moisture-proof properties. For example, the base layer 110 may be formed of polyethylene terephthalte (PET).

The adhesive layer 120 may be provided on one surface of the base layer 110, and more particularly, a lower surface of the base layer 110. Also, the adhesive layer 120 with adhesiveness enables to attach the protecting film 110 to a cover plate ('200' of FIG. 2) to be explained later.

Preferably, the adhesive layer 120 is formed of a material which is easily attached to the cover plate and is easily removed from the cover plate without any foreign matters. The adhesive layer 120 may be formed of rubber-based polymer, silicon-based polymer or acryl-based polymer. In comparison to the adhesive layer 120 of rubber-based polymer, the adhesive layer 120 of acryl-based polymer is more advantageous in that it has less foreign matters when it is removed from the cover plate. Also, in comparison to the adhesive layer 120 of silicon-based polymer, the adhesive layer 120 of acryl-based polymer realizes more-improved adhesiveness to the cover plate. As a result, it is preferable that the adhesive layer 120 be formed of the acryl-based polymer enabling to improve the adhesiveness to the cover plate and to prevent the foreign matters on the cover plate after the removing process.

In addition, the adhesive layer 120 has the various properties. First, the adhesive layer 120 has a surface resistance of 10¹¹ Ω/□(ohms per square) or less, a peel-off static of 1kv or less, an adhesiveness from 29.4 mN/25mm to 88.2 mN/25mm (= 3 gf/25mm to 9 gf/25 mm), a tackiness from 33.32mN to 46.06mN (= 34gf to 47gf), and preferably a hardness of pencil hardness of 4B or greater. The properties of the adhesive layer 120 will be easily understood with the following manufacturing process.

The anti-static layer 130 is provided on the other surface of the base layer 110, and more particularly, an upper surface of the base layer 110, and may be exposed to the external. If static electricity occurs in the upper surface of the base layer 110, the foreign matters may be attached to the upper surface of the base layer 110 due to the static electricity. Thus, the anti-static layer 130 is formed of a conductive material with a low resistance, to thereby minimize the occurrence of static electricity in the protecting film 100. In consideration of anti-static efficiency, a surface resistance of the anti-static layer 130 is 10⁷ Ω/□ or less, preferably. Herein, the surface resistance indicates an average of values of surface resistance measured in a sample having a size of 10cm ×10cm at 100V for 30 seconds.

The anti-static layer 130 may be formed of Poly(3,4-Ethylenedioxythiophene) (PEDOT). Herein, the PEDOT is a conductive polymer, and the PEDOT is utilized as the anti-static layer 130. However, if the anti-static layer 130 is formed of only PEDOT, a bonding force between the anti-static layer 130 and the base layer 110 may be lowered, and a crack may be produced inside the anti-static layer 130. Thus, it is preferable that the anti-static layer 130 be formed by mixing the PEDOT with a binder resin. If the bonding force between the anti-static layer 130 and the base layer 110 is lowered, and the crack is produced inside the anti-static layer 130, there is a high possibility of forming an uneven surface in the anti-static layer 130. In order to satisfy a range of a surface roughness in the anti-static layer 130, both the PEDOT and the binder resin are used to form the anti-static layer 130, preferably.

The adhesive layer 120 includes an anti-static agent including a polyelectrolyte. The PEDOT has an anti-static function by itself so that the PEDOT is used as the material for the anti-static layer 130 without the polyelectrolyte. However, in case of the adhesive layer 120, the various properties to be explained later are required. For this reason, the adhesive layer 120 includes the anti-static agent formed of the polyelectrolyte and an ion-type conductive functional group, instead of using the PEDOT, preferably.

In addition, the anti-static layer 130 may have the various properties, preferably. In detail, the anti-static layer 130 has a surface roughness (Ra). The properties of the anti-static layer 130 will be easily understood with the following manufacturing process.

The release layer 140 is provided on one surface of the adhesive layer 120, and more particularly, an opposite surface of the surface with the base layer 110 attached thereto. The release layer 140 prevents the foreign matters from being attached to the surface of the adhesive layer 120, to thereby minimize deterioration of adhesive properties of the adhesive layer 120. The release layer 140 is separated and removed from the adhesive layer 120 for the following manufacturing process. Preferably, the release layer 140 has heat-resisting and moisture-proof properties. Thus, in the same manner as the base layer 110, the release layer 140 may be formed of Poly(3,4-Ethylenedioxythiophene) (PEDOT). However, since the release layer 140 is separated and removed from the adhesive layer 120, the release layer 140 may be formed of a material without heat-resisting and moisture-proof properties.

According to one embodiment of the present invention, a reflectance of the protecting film 100 is 11% or less, and a reflectance deviation by each position is 3% or less, preferably. Also, in case of the protecting film 100 according to one embodiment of the present invention, a light transmittance is 88.5% or more, and preferably a light transmittance deviation is 3% or less. Also, in case of the protecting film 100 according to one embodiment of the present invention, a haze is 5.5% or less, and preferably a haze deviation is 2% or less. The properties of the protecting film 100 will be easily understood with the following manufacturing process.

FIG. 2 is a cross sectional view illustrating a display module according to one embodiment of the present invention.

As shown in FIG. 2, the display module according to one embodiment of the present invention may include a protecting film 100, a cover plate 200, a display panel 300 and a bonding layer 400.

The protecting film 100 may include a base layer 110, an adhesive layer 120 and an anti-static layer 130. Unlike the protecting film of FIG. 1, in case of the protecting film 100 of FIG. 2, a release layer 140 is removed from the adhesive layer 120, and the adhesive layer 120 is attached to an upper surface of the cover plate 200. A structure for each of the base layer 110, the adhesive layer 120 and the anti-static layer 130 is the same as those of FIG. 1, whereby a detailed description for the base layer 110, the adhesive layer 120 and the anti-static layer 130 will be omitted.

The cover plate 200 is disposed between the protecting film 100 and the bonding layer 400. In more detail, the cover plate 200 is disposed on a lower surface of the protecting film 100, and is disposed on an upper surface of the bonding layer 400. The cover plate 200 may be formed of glass, but not limited to this material. The cover plate 200 may be formed of transparent plastic. The cover plate 200 functions as a front cover of the display panel 300.

The display panel 300 is provided on one surface of the bonding layer 400, and more particularly, an opposite surface of the surface with the cover plate 200 attached thereto. The display panel 300 may be formed of a liquid crystal display panel or an organic light emitting display panel. If the display panel 300 is formed of the liquid crystal display panel, the display panel 300 may include a thin film transistor substrate, a color filter substrate, a liquid crystal layer formed between the thin film transistor substrate and the color filter substrate, a backlight unit for supplying light to the liquid crystal layer, and a driving circuit connected with the thin film transistor substrate. If the display panel 300 is formed of the organic light emitting display panel, the display panel 300 may include a thin film transistor substrate, an organic emitting layer formed on the thin film transistor substrate, a sealing layer formed on the organic emitting layer, and a driving circuit connected with the thin film transistor substrate. A detailed structure of the display panel 300 may be changed in accordance with various modes generally known to those in the art.

The bonding layer 400 is disposed on an upper surface of the display panel 300 and a lower surface of the cover plate 200, whereby the display panel 300 and the cover plate 200 are bonded to each other by the use of bonding layer 400. The bonding layer 400 may be formed of photo-curable adhesive cured by light.

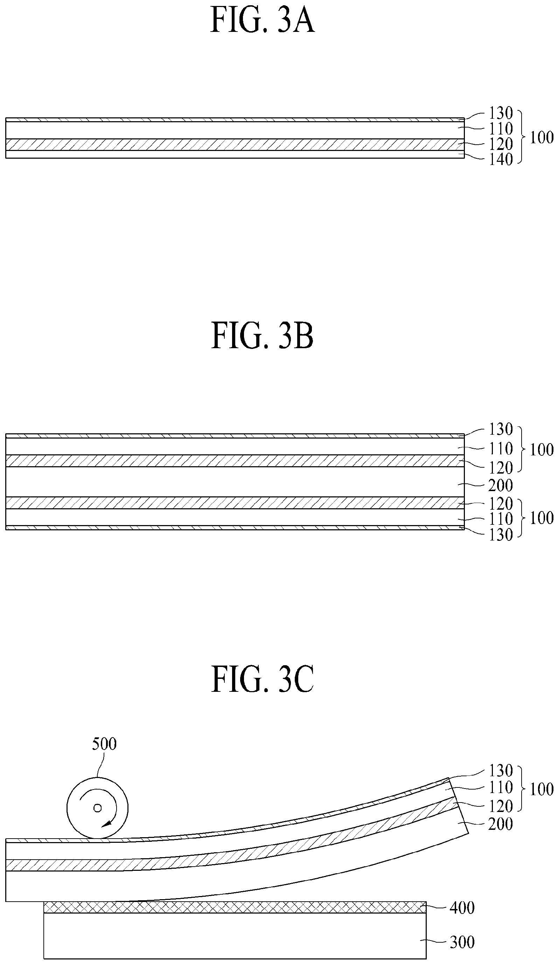

FIGs. 3A to 3F are cross sectional views illustrating a method for manufacturing the display module according to a reference aspect.

First, as shown in FIG. 3A, the release layer is removed from the protecting film 100, which initially comprises the base layer 110, the adhesive layer 120, the anti-static layer 130 and the release layer, and then the protecting film 100 which the release layer is removed therefrom is attached to each of a first surface and an opposing second surface of the cover plate 200. In detail, the protecting film 100 is attached to each of the first surface and the opposing second surface of the cover plate 200 by the adhesive layer 120 in contact with the first surface and the opposing second surface of the cover plate 200. A detailed structure of the protecting film 100 is the same as that of the protecting film shown in FIG. 1. However, the protecting film 110 can be attached to only the first surface of the cover plate 200. That is, the protecting film 110 which the release layer is removed therefrom is attached to at least one surface of the cover plate 200. The protecting film 100, which is referred to as the protecting film 100 for the following description of the manufacturing process, indicates the film which the release layer is removed therefrom.

The cover plate 200 may be formed of glass, but not limited to this material. The cover plate 200 may be formed of transparent plastic. The cover plate 200 functions as a front cover of the display panel, and the cover plate 200 is attached to a front surface of the display panel (See '300' of FIG. 3B). Generally, a process line for manufacturing the cover plate 200 is separately carried out from a process line for attaching the cover plate 200 to the front surface of the display panel (See '300' of FIG. 3B). Thus, after manufacturing the cover plate 200, the protecting film 100 is attached to each of the first surface and the opposing second surface of the cover plate 200 so that it is possible to prevent the surface of the cover plate 200 from being damaged by the foreign matters or being scratched during a transferring process to a next process line.

The properties of the protecting film 100 required for the process of FIG. 3A are shown as follows.

First, in order to remove the release layer from the protecting film 100, a process for fixing the protecting film 100 is carried out by a vacuum suction method. In order to attach the protecting film which the release layer is removed therefrom to each of the first surface and the opposing second surface of the cover plate 200, a process for transferring the protecting film 100 is carried out. Thus, in order to fix or transfer the protecting film 100 by the vacuum suction method, a vacuum chuck or vacuum robot is brought into contact with the surface of the anti-static layer 130. In this case, if a surface roughness of the anti-static layer 130 is too large, a contact area between the anti-static layer 130 and the vacuum chuck or vacuum robot is decreased so that it may have a problem on fixing or transferring the protecting film 100. Meanwhile, if the surface roughness of the anti-static layer 130 is too small, the vacuum chuck or vacuum robot may slide on the surface of the anti-static layer 130, whereby it may have a problem on fixing or transferring the protecting film 100. That is, it may have a problem on fixing or transferring the protecting film 100 by the use of vacuum chuck or vacuum robot.

Second, static electricity may occur by a frictional force during the process of removing the release layer from the protecting film 100. Thus, the adhesive layer 120 being in contact with the release layer is configured to minimize the occurrence of static electricity by the frictional force. In order to minimize the occurrence of static electricity, it is preferable that the adhesive layer 120 have the conductive properties. Especially, a surface resistance of the adhesive layer 120 is 10¹¹ Ω/□(ohms per square) or less. Also, a peel-off static of the adhesive layer 120 is 1kv or less.

After a roll lamination for a sample of 5cm × 125cm on glass, the sample is left on glass for 20 minutes, and the sample is peeled-off on glass at a speed of 300mm/min, and then the static electricity occurring between the sample and glass is measured, to thereby obtain the peel-off static.

In order to prevent the static electricity, an anti-static agent is included in the adhesive layer 120. The anti-static agent includes a polyelectrolyte and an ion-type conductive functional group chemically bonded to the polyelectrolyte. The polyelectrolyte includes Ethylene glycol (C₂H₄(OH)₂) or Ethylene Oxide (C₂H₄O).

The ion-type conductive functional group includes a fluorine-based conductive functional group. The fluorine-based conductive functional group may be a conductive functional group of fluorine-based ion liquid type. The conductive functional group of fluorine-based ion liquid type may be formed of fluorine-based metallic salts (ex, LiBF₄) to which metallic ions such as lithium are bonded. In comparison to an amine-based conductive functional group chemically bonded to the polyelectrolyte, the fluorine-based conductive functional group chemically bonded to the polyelectrolyte realizes more-improved anti-static efficiency.

The ion type conductive functional group is bonded to the polyelectrolyte by a coordinate covalent bonding. Especially, when the anti-static agent is formed by the coordinate covalent bonding of the ion type conductive functional group to the polyelectrolyte, it is possible to minimize elution of the anti-static agent toward the surface of the adhesive layer 120 and transition of the eluted anti-static agent to the surface of cover plate 200. Accordingly, it is possible to minimize a problem of reduction in the peel-off static and the surface resistance of the adhesive layer 120 with lapse of time. This will be described in detail as follows. For providing the anti-static efficiency to the adhesive layer 120, the adhesive layer 120 may include various kinds of anti-static particles generally known to those in the art. In this case, with lapse of time, the anti-static particles may be eluted toward the surface of the adhesive layer 120 and be moved to the surface of the cover plate 200, whereby the peel-off static and surface resistance of the adhesive layer 120 may be reduced with lapse of time. However, in case of one embodiment of the present invention, the anti-static agent included in the adhesive layer 120 contains the ion type conductive functional group chemically bonded to the polyelectrolyte so that it is possible to reduce a problem of elution of the anti-static agent toward the surface of the adhesive layer 120. Especially, when the ion type conductive functional group is coordinate covalent bonded to the polyelectrolyte, it is possible to further reduce a problem of elution of the anti-static agent toward the surface of the adhesive layer 120.

Therefore, the fluorine-based conductive functional group is chemically bonded to the polyelectrolyte by the coordinate covalent bonding state.

Also, when the anti-static agent included in the adhesive layer 120 contains the fluorine-based conductive functional group chemically bonded to the polyelectrolyte, it is possible to realize the super-water-repellent properties of the fluorine-based conductive functional group in addition to the peel-off static and anti-static properties. As a result, it is possible to prevent moisture from being permeated into the adhesive layer 120 during a step of transferring process or manufacturing process. In addition, when the anti-static agent included in the adhesive layer 120 contains the fluorine-based conductive functional group chemically bonded to the polyelectrolyte, it is possible to improve wettability by lowering a surface tension, and to prevent the adhesive layer 120 from protruding out of a lateral side of the cover plate 200 by lowering an interfacial tension, and further to prevent the adhesive layer 120 from being fixed to the cover plate 200 even though the adhesive layer 120 protrudes out of the cover plate 200 in the lateral side direction. The surface tension is a force between the adhesive layer 120 and the cover plate 200. When the surface tension of the adhesive layer 120 is low, the adhesive layer 120 is easily attached to the cover plate 200. The interfacial tension is a force between the adhesive layer 120 and the anti-static agent. If the interfacial tension is small between the anti-static agent and the adhesive layer 120, the anti-static agent and the adhesive layer 120 are easily cross-linked so that it is possible to prevent the adhesive layer 120 from protruding out of the lateral side of the cover plate 200 even in case of an external force. Also, a hardness of the adhesive layer 120 may be increased by lowering the interfacial tension.

Third, the protecting film 100 has to be easily attached to the cover plate 200, and has to be maintained with a predetermined hardness, whereby the protecting film 100 is not detached from the cover plate 200. In order to improve the attachment of the protecting film 100 to the cover plate 200, the adhesive layer 120 of the protecting film 100 has the predetermined adhesiveness and the tackiness property and the predetermined hardness, preferably.

The adhesiveness relates to an attachment-maintaining force between the adhesive layer 120 and the cover plate 200. The tackiness property relates to the attachment properties when the adhesive layer 120 is initially attached to the cover plate 200 and when the adhesive layer 120 is removed from the cover plate 200, and closely relates to wettability. The hardness relates to cohesion of the adhesive layer 120.

In detail, the adhesiveness of the adhesive layer 120 is within a range from 29.4 mN/25mm to 88.2 mN/25mm (= 3 gf/25mm to 9 gf/25 mm ). If the adhesiveness of the adhesive layer 120 is less than 29.4 mN/25mm (= 3 gf/25mm), the protecting film 120 may be easily detached from the cover plate 200. Meanwhile, if the adhesiveness of the adhesive layer 120 is more than 88.2 mN/25mm (= 9 gf/25 mm), it may be difficult to remove the protecting film 100 from the cover plate 200 when the manufactured one is sold to an end-consumer.

The tackiness of the adhesive layer 120 is within a range from 33.32mN to 46.06mN (= 34gf to 47gf). If the tackiness of the adhesive layer 120 is less than 33.32mN (= 34gf), foam or bubble may be produced in the adhesive layer 120 when attaching the protecting film 100 to the cover plate 200, whereby it may be difficult to attach the protecting film 100 to the cover plate 200. Meanwhile, if the tackiness of the adhesive layer 120 is more than 46.06mN (= 47gf), the tackiness of the adhesive layer 120 is too strong, whereby the adhesive layer 120 may be left as the foreign matters on the cover plate 200 and the cover plate 200 may be damaged when removing the protecting film 100 from the cover plate 200. In this specification, the adhesiveness and tackiness properties are values measured by JISZ0237.

Also, it is preferable that the hardness of the adhesive layer 120 be the same as or larger than a pencil hardness 4B. If the hardness of the adhesive layer 120 is the same as or larger than the pencil hardness 4B, even though an external pressure is applied for the manufacturing process, it is possible to reduce spots on the adhesive layer 120, thereby reducing damage on the protecting film 100. Especially, if the adhesive layer 120 has a high hardness of a pencil hardness 1B or larger, the spots are more reduced on the adhesive layer 120. In this case, even though a strong force is applied to the display module, it is possible to prevent the adhesive layer 120 from protruding out of the lateral side of the cover plate 200.

In order to strengthen the hardness of the adhesive layer 120, the adhesive layer 120 is formed of a material with high crosslink density, good thermal-curing efficiency and high glass transition temperature (Tg).

A material of the adhesive layer 120, which satisfies the range of pencil hardness, is an acryl-based polymer including a main monomer and a cross linking agent.

The main monomer may include non-functional monomer and functional monomer.

The non-functional monomer may be formed in a soft type or hard type. If the non-functional monomer is formed in the hard type, it is favorable for the adhesive layer 120 with high hardness of the pencil hardness 1B or larger.

The non-functional monomer of the soft type may include an acrylic ester based monomer, but not limited to this. That is, the non-functional monomer of the soft type may include various monomer generally known to those in the art. For example, the non-functional monomer of the soft type may be selected from groups of methylacrylate, ethylacrylate, isopropylacrylate, n-butylacrylate, ethylhexylacrylate, ethylhexylmethacrylate, and laurylmethacrylate.

The non-functional monomer of the hard type may include a methacrylic ester based monomer, but not limited to this. That is, the non-functional monomer of the hard type may be selected from groups of methylmethacrylate, ethylmethacrylate, n-butylmethacrylate, isobutylmethacrylate, isopropylmethacrylate, styrene, and acrylonitrile.

The functional monomer may include at least one functional group selected from carboxy group, hydroxy group, epoxy group, and amide group, but not limited to these functional groups. The functional monomer may be selected from groups of acrylic acid, methacrylic acid, hydroxyethylacrylate, hydroxyethylmethacrylate, hydroxypropylacrylate, hydroxypropylmethacrylate, glycidylacrylate, glycidylmethacrylate, acrylamide, n-methylolacrylamide, dimethylaminoethylmethacrylate, and methacyloxypropyltrimethoxysilane.

The functional monomer containing hydroxy functional group may be favorable for the adhesive layer 120 with high hardness of the pencil hardness 1B or larger.

The cross linking agent may be formed of isocyanate, but not limited to this material. The cross linking agent may be formed of various materials generally known to those in the art.

The adhesiveness, the tackiness property and the hardness required for the adhesive layer 120 may be influenced by the material of the adhesive layer 120, for example, molecular weight and glass transition temperature of acryl-based polymer.

In more detail, when the glass transition temperature of the material for the adhesive layer 120 is high, the adhesiveness and hardness of the adhesive layer 120 are improved, however, the tackiness property of the adhesive layer 120 is deteriorated. Thus, the material of the adhesive layer 120 is formed of the acryl-based polymer having a predetermined glass transition temperature which satisfies the aforementioned adhesiveness range from 29.4 mN/25mm to 88.2 mN/25mm (= 3 gf/25mm to 9 gf/25 mm), the preferable hardness range of the pencil hardness of 4B or greater and the tackiness range from 33.32mN to 46.06mN (= 34gf to 47gf).

According to one embodiment of the present invention, in order to improve the adhesiveness and hardness of the adhesive layer 120, the acryl-based polymer with high glass transition temperature may be used for the material of the adhesive layer 120. In order to overcome the deterioration of tackiness property, the anti-static agent included in the adhesive layer 120 is formed of the fluorine-based conductive functional group. For example, the material of the adhesive layer 120 is formed of the non-functional monomer of the hard type and the functional monomer containing hydroxy (OH) functional group so that it is possible to improve the adhesiveness and hardness of the adhesive layer 120. Also, the anti-static agent containing the fluorine-based conductive functional group chemically bonded to the polyelectrolyte is included in the adhesive layer 120 so that it is possible to improve the tackiness property of the adhesive layer 120.

If the molecular weight of the material for the adhesive layer 120 is high, the adhesiveness and hardness of the adhesive layer 120 is improved, however, the tackiness property of the adhesive layer 120 is deteriorated. Thus, the material of the adhesive layer 120 is formed of the acryl-based polymer having a predetermined molecular weight which satisfies the aforementioned adhesiveness range from 29.4 mN/25mm to 88.2 mN/25mm (= 3 gf/25mm to 9 gf/25 mm), the preferable hardness range of the pencil hardness of 4B or greater and the tackiness range from 33.32mN to 46.06mN (= 34gf to 47gf). In detail, when the molecular weight of the acryl-based polymer is within a range from 400,000 to 500,000, it is possible to satisfy the adhesiveness, hardness and tackiness properties.

Then, as shown in FIG. 3B, the display panel 300 is prepared, and the bonding layer 400 is formed on one surface (upper surface with reference to FIG. 3B) of the display panel 300. Also, the protecting film 100 is removed from the opposing second surface (lower surface with reference to FIG. 3B) of the cover plate 200 in case the protecting film 100 is attached to both the first surface and opposing second surface of the cover plate 200. Under the condition that the bonding layer 400 confronts with the opposing second surface of the cover plate 200, the opposing second surface of the cover plate 200 is placed in contact with a bonding layer 400 on one surface of the display panel 300, and the the cover plate 200 is attached to the bonding layer 400 by the use of roll 500.

In case the protecting film 100 is attached to only a first surface of the cover plate 200, the opposing second surface of the cover plate 200 is placed in contact with a bonding layer 400 on one surface of a display panel 300 without the process of removing the protecting film 100 from the opposing second surface of the cover plate 200, and the cover plate 200 is attached to the bonding layer 400 by the use of roll 500.

The cover plate 200 is attached to the display panel 300. Thus, there is no need to attach the protecting film 100 to the opposing second surface of the cover plate 200 since the opposing second surface of the cover plate 200 corresponds to the surface to be attached to the display panel 300. Thus, the protecting film 100 is removed from the opposing second surface of the cover plate 200. Also, additional elements are not attached to the first surface of the cover plate 200 (upper surface with reference to FIG. 3B) for the following manufacturing process. Accordingly, the protecting film 100 is not removed from the first surface of the cover plate 200.

The protecting film 100 attached to the first surface of the cover plate 200 is left on the first surface of the cover plate 200 after the following manufacturing process, however, the protecting film 100 attached to the opposing second surface of the cover plate 200 is removed from the opposing second surface of the cover plate 200. Accordingly, the properties required for the protecting film 100 attached to the first surface of the cover plate 200 are different from the properties required for the protecting film 100 attached to the opposing second surface of the cover plate 200. That is, in comparison to the protecting film 100 attached to the opposing second surface of the cover plate 200 and removed from the opposing second surface of the cover plate 200, the protecting film 100 attached to the first surface of the cover plate 200 and left on the first surface of the cover plate 200 for the following manufacturing process is put into more process lines, whereby the properties required for the protecting film 100 attached to the first surface of the cover plate 200 are stricter than the properties required for the protecting film 100 attached to the opposing second surface of the cover plate 200. Accordingly, the protecting film 100 attached to the first surface of the cover plate 200 may be differently manufactured from the protecting film 100 attached to the opposing second surface of the cover plate 200. According to circumstances, the protecting film 100 attached to the first surface of the cover plate 200 and the protecting film 100 attached to the opposing second surface of the cover plate 200 may be manufactured identically. If the protecting film 100 attached to the first surface of the cover plate 200 and the protecting film 100 attached to the opposing second surface of the cover plate 200 are manufactured identically, the properties of the protecting film 100 attached to the opposing second surface of the cover plate 200 are controlled in accordance with the stricter properties of the protecting film 100 attached to the first surface of the cover plate 200.

The display panel 300 may be formed of the liquid crystal display panel or the organic light emitting display panel. If the display panel 300 is formed of the liquid crystal display panel, the display panel 300 may include the thin film transistor substrate, the color filter substrate, the liquid crystal layer formed between the thin film transistor substrate and the color filter substrate, and the driving circuit connected with the thin film transistor substrate. If the display panel 300 is formed of the organic light emitting display panel, the display panel 300 may include the thin film transistor substrate, the organic emitting layer formed on the thin film transistor substrate, the sealing layer formed on the organic emitting layer, and the driving circuit connected with the thin film transistor substrate. The display panel 300 includes the driving circuit for an image test of the following process. A detailed structure of the display panel 300 may be changed in accordance with various modes generally known to those in the art.

The properties of the protecting film 100 required for the process of FIG. 3B are shown as follows.

First, in order to remove the protecting film 100 from the opposing second surface of the cover plate 200, the vacuum chuck is brought into contact with the surface of the anti-static layer 130 disposed on the first surface of the cover plate 200.

Second, in order to accurately attach the cover plate 200 onto the bonding layer 400, an alignment process for the cover plate 200 is carried out. The alignment process for the cover plate 200 is carried out by sensing a corner of the cover plate 200 through the use of video camera above the protecting film 100. In this case, if the reflectance of the protecting film 100 is large or the reflectance deviation by each position is large, it may be difficult to sense the corner of the cover plate 200 by the use of video camera. Preferably, the reflectance of the protecting film 100 is 11% or less, and the reflectance deviation by each position is 3% or less. The protecting film 100 includes the base layer 110, the adhesive layer 120 and the anti-static layer 130. Thus, the reflectance in each of the base layer 110, the adhesive layer 120 and the anti-static layer 130 may be 11% or less, and the reflectance deviation by each position may be 3% or less. If satisfying that the reflectance of the protecting film 100 is 11% or less and the reflectance deviation by each position is 3% or less, it is possible that the reflectance of at least one of the base layer 110, the adhesive layer 120 and the anti-static layer 130 is more than 11% and the reflectance deviation by each position is more than 3%. In this specification, the reflectance property is a value measured by ASTM D1003.

As shown in FIG. 3C, light or heat is irradiated through the protecting film 100, to thereby cure the bonding layer 400. The bonding layer 400 may be formed of photo-curing adhesive or thermal-curing adhesive. Thus, the bonding layer 400 may be cured by the photo or heat irradiation. If the bonding layer 400 is cured by the photo irradiation, the photo irradiation process may be a process for irradiating ultraviolet (UV) rays.

The properties of the protecting film 100 required for the process of FIG. 3C are shown as follows.

If the bonding layer 400 is cured by the photo irradiation, light passes through the protecting film 100 so as to cure the bonding layer 400. If the light transmittance of the protecting film 100 is low, the bonding layer 400 is not cured. Accordingly, the light transmittance of the protecting film 100 is 88.5% or more. The light transmittance for each of the base layer 110, the adhesive layer 120 and the anti-static layer 130 may be 88.5% or more. In this specification, the property of the light transmittance is a value measured by ASTM D1003.

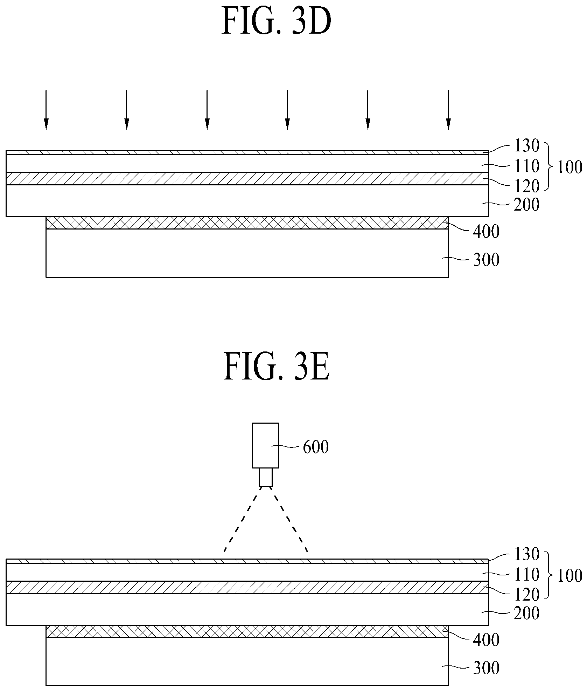

Then, as shown in FIG. 3D, the image inspection process for the display panel 300 is carried out under the condition that the cover plate 200 is attached to the display panel 300.

The image inspection process is carried out after an image inspection device 600 is positioned above the protecting film 100. The inspection using the image inspection device 600 may be changed in accordance with the kind of the display panel 300.

The properties of the protecting film 100 required for the process of FIG. 3D are shown as follows.

For the image inspection, the light transmittance of the protecting film 100 should be high, and the light transmittance deviation by each position should be small. If the light transmittance is low, it is difficult to carry out the image inspection. If the light transmittance deviation by each position is large, errors may occur during the image inspection. Accordingly, the light transmittance of the protecting film 100 is 88.5% or more, and the light transmittance deviation by each position is preferably 3% or less. The protecting film 100 comprises the base layer 110, the adhesive layer 120 and the anti-static layer 130. Accordingly, the light transmittance for each of the base layer 110, the adhesive layer 120 and the anti-static layer 130 may be 88.5% or more, and the light transmittance deviation by each position may be 3% or less.

For the image inspection, the haze of the protecting film 100 should be small, and the haze deviation by each position should be small. If the haze of the protecting film 100 is high, it is difficult to carry out the image inspection. If the haze deviation by each position is large, errors may occur during the image inspection. Accordingly, the haze of the protecting film 100 is 5.5% or less, and the haze deviation by each position is preferably 2% or less. The protecting film 100 comprises the base layer 110, the adhesive layer 120 and the anti-static layer 130. Accordingly, the haze for each of the base layer 110, the adhesive layer 120 and the anti-static layer 130 may be 5.5% or less, and the haze deviation by each position may be 2% or less. In this specification, the haze property is a value measured by ASTM D1003.

In the above FIGs. 3C and 3D, after the cover plate 200 is perfectly fixed to the display panel 300 by completely curing the bonding layer 400, the image inspection process is carried out, but not necessarily.

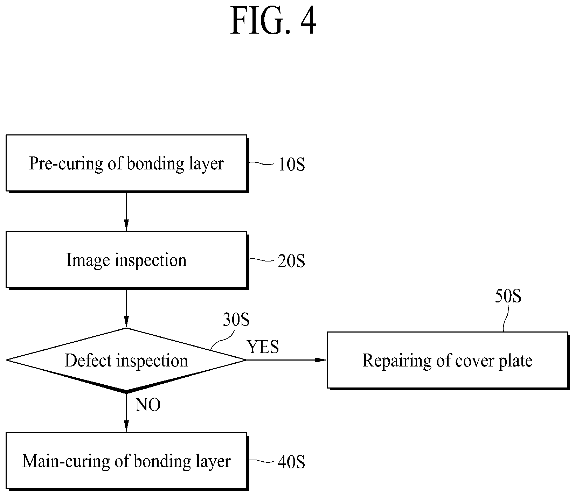

In detail, if there is an alignment error of the cover plate 200 based on results of the image inspection, a process for repairing the cover plate 200 may be additionally carried out. If the bonding layer 400 is completely cured, it may be difficult to separate the cover plate 200 from the display panel 300. A method for facilitating the repairing process of the cover plate 200 may be needed, which will be described with reference to FIG. 4.

FIG. 4 is a flow chart showing a process for attaching the cover plate 200 to the display panel 300 according to another reference aspect, which will be described with reference to FIG. 4 and FIGs. 3B to 3D.

First, a cover plate 200 is positioned above a bonding layer 400, and then the bonding layer 400 is pre-cured (10S). The pre-curing process of the bonding layer 400 may be carried out by UV irradiation. The bonding layer 400 is not completely cured by controlling time and intensity of UV irradiation. By the pre-curing process of the bonding layer 400, the cover plate 200 is temporarily fixed to the display panel 300. Herein, the pre-curing indicates a state of 10% to 40% of curing rate. The curing rate may be measured by HPLC (High Performance Liquid Chromatography) or FT-IR (Fourier Transform Infrared Spectroscopy) method. In case of the HPLC method, the curing rate is measured by dissolving and curing a target object, and counting the number of the cured molecules whose molecular weight is large, and the number of the non-cured molecules whose molecular weight is small. In case of the FT-IR method, the curing rate is measured by thinly flattening a target object at a uniform thickness and detecting a UV absorption wavelength peak in accordance with the molecular weight.

Then, the image inspection process is carried out over the protecting film 100 attached to the upper surface of the cover plate 200 (20S), to thereby inspect defects in the cover plate 200 (30S). The image inspection process (20S) may be carried out by the use of aforementioned image inspection device 600.

Then, based on the results of defect inspection, a main curing process (40S) for the bonding layer 400 is carried out if it is determined that there is no defect in the cover plate 200 (No), and the cover plate 200 is repaired (50S) if it is determined that there is the defect in the cover plate 200 (Yes).

This main curing process of the bonding layer 400 is carried out by UV irradiation. The UV irradiation time of this main curing process may be longer than the UV irradiation time of the pre-curing process, and the UV irradiation intensity of this main curing process may be stronger than the UV irradiation intensity of the pre-curing process. By this main curing process of the bonding layer 400, the cover plate 200 is completely fixed to the display panel 300. In this specification, the main curing indicates a state of curing rate above 90%.

The repairing process of the cover plate 200 may include separating the cover plate 200 from the display panel 300, and again carrying out the aforementioned processes of FIG. 3B and FIG. 3C.

As shown in FIG. 3E, the backlight unit 350 is assembled on the other surface of the display panel 300, wherein the other surface of the display panel 300 corresponds to the surface to which the cover plate 200 is not attached.

If the display panel 300 is the liquid crystal display panel, the assembling process of the backlight unit 350 is carried out. Meanwhile, if the display panel 300 is the organic light emitting display panel, the assembling process of the backlight unit 350 is not carried out.

For the assembling process of the backlight unit 350, the other surface of the display panel 300, to which the cover plate 200 is not attached, faces upward, and the backlight unit 350 is disposed on the other surface of the display panel 300.

The properties of the protecting film 100 required for the process of FIG. 3E are shown as follows.

For the assembling of the backlight unit 350, the other surface of the display panel 300, to which the cover plate 200 is not attached, faces upward so that the protecting film 100 attached to the cover plate 200 is positioned down. During the assembling process of the backlight unit 350, if an external pressure is applied to the backlight unit 350, the adhesive layer 120 included in the protecting film 100 may be deformed.

Thus, in order to prevent the deformation of the adhesive layer 120, it is good to provide the adhesive layer 120 with strong hardness. In detail, the hardness of the adhesive layer 120 is preferable to be the pencil hardness of 4B or greater, and more preferably, the pencil hardness 1B or larger.

Although not shown, under the condition that the backlight unit 350 is assembled on the display panel 300, the image inspection process for the display panel 300 may be carried out. In the same manner as the process of FIG. 3E, the light transmittance property and the haze property for the protecting film 100 are required, which are the same as those described above, whereby a repetitive explanation for the same parts will be omitted.

Also, a process for testing an operation of the display module at a high temperature may be carried out. In this case, after the display module is left at a high temperature for a long period of time, it is tested whether or not the display module is operated. If the display module is left at a high temperature for a long period of time, the adhesiveness of the adhesive layer 120 may be deteriorated. Thus, even though the display module is left at a high temperature for a long period of time, the adhesiveness of the adhesive layer 120 should be maintained without change. If the adhesive layer 120 is formed of material with high crosslink density, good thermal-curing efficiency and high glass transition temperature (Tg), such as the acryl-based polymer including the main monomer and the cross linking agent, the adhesiveness of the adhesive layer 120 is maintained without any change under the high-temperature condition for a long period of time.

After completing the manufacturing of display module, a process for loading the display module is carried out. For the loading process, the alignment of the display module is carried out through the use of video camera. In order to smoothly carry out the alignment process of the display module, the reflectance property of the protecting film 100, shown in the above process of FIG. 3C, is required, wherein a repetitive description for the reflectance property required will be omitted.

In the display module manufactured by the above processes, the protecting film 100 is attached to the front surface of the cover plate 200. However, in case of the manufactured good to be sold to an end-consumer, the protecting film 100 may be removed from the front surface of the cover plate 200.

According to the present invention, the protecting film allowing the various properties required for the respective manufacturing processes is manufactured so that it is no need to replace the protecting film every manufacturing process. Accordingly, it is possible to overcome a problem of increase of manufacturing time and cost due to removing, cleaning and re-attaching steps of the protecting film. In addition, it is possible to prevent the surface of cover plate from being damaged by the repetitive replacement of the protecting film.

## Claims

1. A protecting film (100) comprising:
a base layer (110) ;
an anti-static layer (130) on one surface of the base layer (110); and
an adhesive layer (120) on the other surface of the base layer (110),
**characterized in that** the adhesive layer (120) comprises an anti-static agent in which a polyelectrolyte including ethylene glycol or ethylene oxide and an ion-type conductive functional group comprising a fluorine-based conductive functional group are coordinate covalently bonded,
wherein the adhesive layer (120) has a surface resistance of 10¹¹ Ω/□(ohms per square) or less, a peel-off static of 1 kv or less, an adhesiveness from 29.4 mN/25mm to 88.2 mN/25mm (= 3 gf/25mm to 9 gf/25 mm), and a tackiness from 33.32mN to 46.06mN (= 34gf to 47gf), and
wherein the light transmittance of the protecting film (100) is 88.5% or more, and the haze of the protecting film (100) is 5.5% or less.

2. The protecting film (100) according to claim 1, wherein the hardness of the adhesive layer (120) is a pencil hardness of 4B or greater.

3. The protecting film (100) according to any one of claims 1 to 2, wherein the reflectance of the protecting film (100) is 11% or less, the reflectance deviation of the protecting film (100) is 3% or less, the light transmittance deviation of the protecting film (100) is 3% or less, and the haze deviation of the protecting film (100) is 2% or less.

4. A display module comprising: a display panel (300) and a cover plate (200) with the protecting film (100) according to any one of claims 1 to 3.

## Patentansprüche

1. Schutzfilm (100), umfassend:
eine Grundschicht (110),
eine antistatische Schicht (130) auf einer Fläche der Grundschicht (110) und
eine Klebeschicht (120) auf der anderen Fläche der Grundschicht (110),
**dadurch gekennzeichnet, dass** die Klebeschicht (120) ein antistatisches Mittel umfasst, in dem ein Polyelektrolyt, der Ethylenglycol oder Ethylenoxid aufweist, und eine leitende funktionelle Gruppe vom Ionentyp, die eine fluorbasierte leitende funktionelle Gruppe umfasst, koordinativ kovalent gebunden sind,
wobei die Klebeschicht (120) einen Flächenwiderstand von 10¹¹ Ω/□ (Ohm pro Quadrat) oder weniger, eine statische Abziehladung von 1 kV oder weniger, eine Haftfähigkeit von 29,4 mN/25 mm bis 88,2 mN/25 mm (= 3 gf/25 mm bis 9 gf/25 mm) und eine Klebrigkeit von 33,32 mN bis 46,06 mN (= 34 gf bis 47 gf) hat und
wobei die Lichtdurchlässigkeit des Schutzfilms (100) 88,5 % oder mehr beträgt und die Trübung des Schutzfilms (100) 5,5 % oder weniger beträgt.

2. Schutzfilm (100) nach Anspruch 1, wobei die Härte der Klebeschicht (120) eine Bleistifthärte von 4B oder mehr ist.

3. Schutzfilm (100) nach einem der Ansprüche 1 bis 2, wobei das Reflexionsvermögen des Schutzfilms (100) 11 % oder weniger beträgt, die Reflexionsabweichung des Schutzfilms (100) 3 % oder weniger beträgt, die Lichtdurchlässigkeitsabweichung des Schutzfilms (100) 3 % oder weniger beträgt und die Trübungsabweichung des Schutzfilms (100) 2 % oder weniger beträgt.

4. Anzeigemodul, umfassend:
eine Anzeigetafel (300) und eine Abdeckungsplatte (200) mit dem Schutzfilm (100) nach einem der Ansprüche 1 bis 3.

## Revendications

1. Film de protection (100) comprenant :
une couche de base (110) ;
une couche antistatique (130) sur une surface de la couche de base (110) ; et
une couche adhésive (120) sur l'autre surface de la couche de base (110),
**caractérisé en ce que** la couche adhésive (120) comprend un agent antistatique dans lequel un polyélectrolyte incluant de l'éthylène glycol ou de l'oxyde d'éthylène et un groupe fonctionnel conducteur de type ion comprenant un groupe fonctionnel conducteur à base de fluor sont liés par liaisons covalentes coordonnées,
dans lequel la couche adhésive (120) présente une résistance de surface inférieure ou égale à 10¹¹ Ω/□ (ohms par carré), une énergie statique de détachement inférieure ou égale à 1 kV, une adhésivité de 29,4 mN/25 mm à 88,2 mN/25 mm (de 3 gf/25 mm à 9 gf/25 mm), et une adhérence de 33,32 mN à 46,06 mN (de 34 gf à 47 gf), et
dans lequel la transmittance lumineuse du film de protection (100) est supérieure ou égale à 88,5 %, et le flou du film de protection (100) est inférieur ou égal à 5,5 %.

2. Film de protection (100) selon la revendication 1, dans lequel la dureté de la couche adhésive (120) est une dureté au crayon supérieure ou égale à 4B.

3. Film de protection (100) selon la revendication 1 ou 2, dans lequel la réflectance du film de protection (100) est inférieure ou égale à 11 %, l'écart de réflectance du film de protection (100) est inférieur ou égal à 3 %, l'écart de transmittance lumineuse du film de protection (100) est inférieur ou égal à 3 %, et l'écart de flou du film de protection (100) est inférieur ou égal à 2 %.

4. Module d'affichage comprenant :
un panneau d'affichage (300) et une plaque de recouvrement (200) avec le film de protection (100) selon l'une quelconque des revendications 1 à 3.
